Europäisches Patentamt

European Patent Office

Office européen des brevets

(19)

(11) Numéro de publication : **0 415 503 B1**

## (12) FASCICULE DE BREVET EUROPEEN

(45) Date de publication du fascicule du brevet :
28.12.94 Bulletin 94/52

(51) Int. Cl.⁵ : **H03F 1/32, H03G 3/20**

(21) Numéro de dépôt : **90202304.3**

(22) Date de dépôt : **28.08.90**

(54) Circuit intégré présentant une détection d'état de saturation.

(30) Priorité : **01.09.89 FR 8911491**

(43) Date de publication de la demande :
**06.03.91 Bulletin 91/10**

(45) Mention de la délivrance du brevet :
**28.12.94 Bulletin 94/52**

(84) Etats contractants désignés :
**DE FR GB IT**

(56) Documents cités :
**EP-A- 0 156 411
EP-A- 0 309 063
EP-A- 0 328 180
GB-A- 2 135 483**

(73) Titulaire : **PHILIPS COMPOSANTS
4, rue du Port aux Vins
F-92150 Suresnes (FR)**
(84) **FR**
Titulaire : **Philips Electronics N.V.
Groenewoudseweg 1
NL-5621 BA Eindhoven (NL)**
(84) **DE GB IT**

(72) Inventeur : **Jouen, Philippe
Societe Civile S.P.I.D.,
156 Bd Haussmann
F-75008 Paris (FR)**

(74) Mandataire : **Charpail, François et al
Société Civile S.P.I.D.
156, Boulevard Haussmann
F-75008 Paris (FR)**

## Description

"Circuit intégré présentant une détection d'état de saturation".

La présente invention a pour objet un circuit intégré comportant un dispositif de détection de l'état de saturation d'au moins un transistor de sortie dont le trajet collecteur-émetteur est destiné à être traversé par un courant de sortie et comportant un circuit à seuil agencé pour commuter lorsqu'un paramètre représentatif d'un état de saturation franchit un seuil donné.

La saturation d'un transistor se traduit par une diminution de sa tension collecteur-émetteur $V_{ce}$ et il est bien connu de réaliser une détection de saturation à l'aide d'un circuit à seuil qui commute lorsque la tension $V_{ce}$ descend en dessous d'un seuil donné. Une telle détection peut alors être utilisée pour commander un étage de contrôle automatique de gain de manière à faire baisser le gain d'un amplificateur dont un transistor de sortie fait l'objet de la détection.

Un domaine d'application d'un tel système de contrôle de gain en fonction de l'état de saturation d'un transistor de sortie d'un amplificateur est un dispositif d'écoute amplifiée pour un récepteur téléphonique. Dans un tel cas, il faut choisir le seuil donné de manière que, dans le pire des cas d'utilisation (faible charge extérieure, forte température) et en tenant compte des tolérances du procédé de fabrication du circuit intégré, le transistor de sortie ne sature jamais. Il résulte cependant d'un tel choix qu'on limite exagérément le signal maximal qui peut être obtenu dans des conditions normales d'utilisation.

La présente invention a pour but d'obtenir une détection améliorée de l'état de saturation en détectant un phénomène spécifique caractérisant le passage d'un transistor à l'état de saturation.

La Demanderesse a en effet constaté que, pour les transistors réalisés par les procédés usuels de fabrication de circuits intégrés, le phénomène de saturation s'accompagnait d'un fort accroissement du courant de base à fournir, en raison de la mise en conduction de transistors parasites (de type pnp pour une technologie à substrat p). A titre d'exemple, une légère saturation peut suffire à faire passer le courant de base d'un centième à un dixième de la valeur du courant de collecteur.

Le circuit intégré selon l'invention est dans ce but caractérisé en ce qu'il comporte un transistor de commande agencé de manière à fournir au moins une partie du courant de base du transistor de sortie et en ce que le circuit à seuil est agencé pour commuter lorsque la valeur du courant traversant le trajet collecteur-émetteur du transistor de commande dépasse un niveau donné.

Selon un premier mode de réalisation, le circuit à seuil comporte une première diode disposée en série entre ledit trajet collecteur-émetteur du transistor de commande et une source de tension d'alimentation, une deuxième diode disposée en série entre une première source de courant d'intensité donnée et la source de tension d'alimentation, le point commun à la première diode et audit trajet collecteur-émetteur du transistor de commande étant connecté à une première entrée d'un premier amplificateur différentiel et le point commun à la deuxième diode et à la première source de courant étant connecté à une deuxième entrée du premier amplificateur différentiel.

On obtient ainsi en sortie du premier amplificateur différentiel un signal qui commute pour un niveau de courant fixé par le choix de l'intensité de la première source de courant.

Selon un deuxième mode de réalisation, le circuit à seuil comporte une première branche série, comprenant une deuxième diode et une première résistance, et disposée en série entre ledit trajet collecteur-émetteur du transistor de commande et la source de tension d'alimentation, et un premier transistor de contrôle dont la base est connectée au point commun entre la première branche série et le trajet collecteur-émetteur du transistor de commande, le trajet collecteur-émetteur du premier transistor de contrôle étant connecté d'une part à une première borne d'une deuxième résistance dont la deuxième borne est connectée à la source de tension d'alimentation et d'autre part à la base du transistor de sortie, en ce que la base du premier transistor de contrôle est connectée à la base d'un deuxième transistor de contrôle dont le trajet collecteur-émetteur est connecté d'une part à une première borne d'une troisième diode en direct dont la deuxième borne est connectée à la source de tension d'alimentation et d'autre part à une première borne d'une quatrième diode dont la deuxième borne est connectée à une deuxième source de tension d'alimentation, en ce qu'il comporte une deuxième source de courant d'intensité donnée connectée en série avec une première borne d'une cinquième diode en direct dont la deuxième borne est connectée à la deuxième source de tension d'alimentation, en ce que la première borne de la quatrième diode est connectée à une première entrée d'un deuxième amplificateur différentiel et en ce que la première borne de la cinquième diode est connectée à une deuxième entrée du deuxième amplificateur différentiel.

Selon un troisième mode de réalisation, un circuit selon l'invention comporte un troisième transistor de contrôle dont la base est connectée à celle du transistor de commande et dont le trajet collecteur-émetteur est connecté d'une part à une première borne d'une sixième diode en direct dont la deuxième borne est connectée à la première source de tension d'alimentation et d'autre part à la base du transistor de sortie, en ce qu'il comporte une septième diode dont une première borne est connectée à une troisième source de courant d'intensité donnée et dont une deuxième borne est connectée à la première source de tension d'alimentation, en ce que la première borne de la sixième diode est connectée à une première entrée d'un troisième amplificateur différentiel et en ce que la première borne de la septième diode est connectée à une deuxième entrée du troisième amplificateur différentiel.

Les trois modes de réalisation précités présentent l'avantage, en raison de la présence de diodes, de pouvoir utiliser un même amplificateur différentiel pour contrôler simultanément des transistors de sortie en opposition de phase.

La sortie du circuit à seuil, par exemple d'au moins un des amplificateurs différentiels peut être connectée, de manière connue en soi, à l'entrée d'un circuit de commutation dont la sortie est agencée pour charger ou décharger un condensateur de mémorisation en fonction de la polarité de la tension en sortie dudit circuit à seuil, ledit condensateur ayant une borne reliée à une entrée de contrôle de gain d'un circuit de contrôle de gain d'un circuit amplificateur qui comporte ledit transistor de sortie.

Le circuit peut avantageusement comporter :
- un régulateur shunt agencé pour réguler à une première valeur de référence la tension d'alimentation du circuit amplificateur, le circuit de contrôle de gain étant agencé pour agir sur le gain du circuit amplificateur au moins en fonction du courant traversant le régulateur shunt ;
- un premier moyen pour faire varier selon une première loi de variation ladite tension mémorisée par le condensateur de mémorisation, dans un premier sens correspondant à une augmentation du gain lorsque le régulateur shunt est traversé par un courant et pour interrompre cette action dans le cas contraire ;
- et un deuxième moyen pour faire varier selon une deuxième loi de variation plus rapide que la première ladite tension mémorisée dans un deuxième sens opposé au premier lorsque la tension d'alimentation disponible aux bornes d'alimentation de l'amplificateur descend en dessous d'une deuxième valeur de référence inférieure à la première valeur de référence.

La deuxième valeur de référence peut être voisine de la tension d'alimentation minimale correspondant à un fonctionnement correct de l'amplificateur.

Le premier moyen comporte avantageusement un comparateur de courant pour comparer le courant traversant le régulateur shunt à un courant de référence.

Selon un mode de réalisation préféré, le circuit comporte une résistance dont une première borne est connectée à ladite borne du condensateur et dont une deuxième borne est connectée à ladite entrée de contrôle de gain et la sortie du circuit de commutation est connectée à ladite borne du condensateur.

Le condensateur est ainsi en cas de baisse de la tension d'alimentation, déchargé à travers une résistance qui procure une constante de temps proportionnée aux variations relativement lentes de la tension d'alimentation et en cas de saturation décharge sans constante de temps.

La présente invention sera mieux comprise à la lecture de la description qui va suivre donnée à titre d'exemple non limitatif, en liaison avec les dessins qui représentent :
- la figure 1, un circuit de détection de l'art antérieur associé à une commande de contrôle automatique de gain,
- la figure 2, un circuit de détection selon l'invention, associé à une commande de contrôle automatique de gain,
- la figure 3a, un mode de réalisation de l'invention, comprenant une détection de saturation pour chacun des deux transistors de sortie et la figure 3b, un circuit de contrôle automatique de gain associé à la figure 3a.
- la figure 4 un autre mode de réalisation de l'invention.
- et les figures 5 et 6 des modes de réalisations préférés de l'invention.

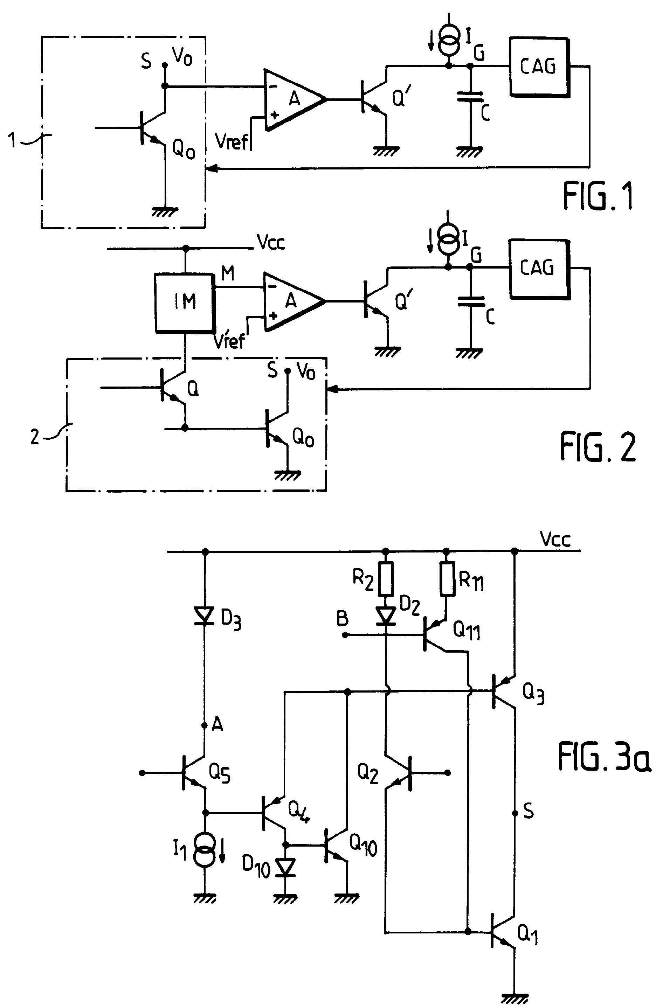

Selon la figure 1, un amplificateur 1 présente un transistor de sortie $Q_0$ de type npn dont le collecteur (point S) délivre une tension de sortie $V_0$, et dont l'émetteur est connecté au pôle de mode commun (masse). La tension au point S est comparée à une tension de référence $V_{ref}$. A cet effet, le point S est connecté à l'entrée inverseuse d'un amplificateur différentiel A dont l'entrée non inverseuse est portée au potentiel $V_{ref}$. Lorsque $V_0$ devient inférieure à $V_{ref}$, la sortie de l'amplificateur A commute au niveau haut. Cette sortie est connectée à la base d'un transistor Q' de type npn dont l'émetteur est à la masse et dont le collecteur est connecté à une source de courant I ainsi qu'à une première borne d'un condensateur de mémorisation C dont l'autre borne est à la masse. Lorsque la sortie de l'amplificateur A est au niveau haut, le transistor Q' est passant et le condensateur C se décharge. La première borne du condensateur C attaque l'entrée de contrôle de gain d'un circuit de contrôle de gain de l'amplificateur A. La décharge totale ou partielle du condensateur C induit une diminution du gain de l'amplificateur 1, laquelle tend à son tour à désactiver le transistor $Q_0$.

Un tel dispositif est par exemple mis en oeuvre sur le circuit TEA 1064 de Philips, utilisé à des fins d'amplification d'écoute téléphonique. Il permet d'éliminer l'écrêtage en tension provoqué par la saturation du ou des transistors de sortie. Un tel écrêtage est en effet de nature à apporter une distorsion élevée sur le signal de sortie, et cette distorsion croît très vite avec le niveau du signal d'entrée.

En fonctionnement, sur les pics de signaux, $V_0$ devient légèrement inférieure à $V_{ref}$ et le transistor Q'

décharge alors pendant un court instant le condensateur C avec un courant très supérieur à I. A L'équilibre, avec des signaux de niveau élevé, le transistor Q′ conduit pendant une fraction de période juste suffisante pour annuler la charge apportée par le courant I. Dans le cas de signaux tels que la parole où les niveaux changent fréquemment, il est souhaitable qu'une diminution du gain soit obtenue avec une constante de temps très courte (par exemple quelques millisecondes). Par contre, si on veut éviter un phénomène de pompage, la recharge du condensateur a de préférence une constante de temps beaucoup plus élevée (100 à 200 millisecondes par exemple).

Le choix de la valeur de $V_{ref}$ dépend cependant de plusieurs paramètres. Il faut en pratique choisir $V_{ref}$ à une valeur suffisamment élevée pour que, compte tenu du pire cas de fonctionnement (faible impédance de charge, température élevée) et des dispersions du procédé de fabrication, la saturation ne soit jamais atteinte. Ceci conduit à choisir une valeur de $V_{ref}$ qui limite le signal maximal que l'on peut obtenir dans des conditions normales d'utilisation.

La figure 2 correspond à une détection selon l'invention, selon laquelle le début de l'état de saturation est détecté directement, ce qui veut dire que le seuil choisi correspond au maximum de saturation que l'on accepte, mais ne doit plus tenir compte des divers cas de fonctionnement ou des dispersions du procédé de fabrication. On assure donc une faible distortion maximale tout en permettant à $V_0$ d'atteindre la valeur maximale de signal compatible avec cette distorsion. Au transistor $Q_0$ est associé un transistor de commande Q qui fournit au moins une partie du courant de base du transistor $Q_0$. Le transistor Q est représenté comme étant le transistor amont d'un étage Darlington, la base du transistor Q étant attaquée par le signal d'entrée, et son collecteur présentant un circuit IM susceptible de produire en sortie un signal de mesure M représentatif du courant traversant le trajet de courant principal (collecteur-émetteur) du transistor $Q_0$. La boucle de contrôle automatique de gain est sensiblement identique à celle de la figure 1, le signal M étant introduit à l'entrée inverseuse de l'amplificateur A, dont l'entrée non inverseuse est portée à une tension de référence $V'_{ref}$. Lorsque le transistor $Q_0$ commence à se saturer, un transistor parasite, dont l'existence résulte des propriétés des procédés usuels de fabrication de transistors bipolaires, commence à conduire, ce qui a pour effet d'augmenter très rapidement le courant de base du transistor $Q_0$, et donc le courant collecteur-émetteur du transistor de commande Q. On obtient un effet de seuil extrêmement sensible, car la valeur du courant de base du transistor $Q_0$ peut être multipliée par 10 (passant par exemple d'un centième de la valeur du courant collecteur à un dixième de cette valeur).

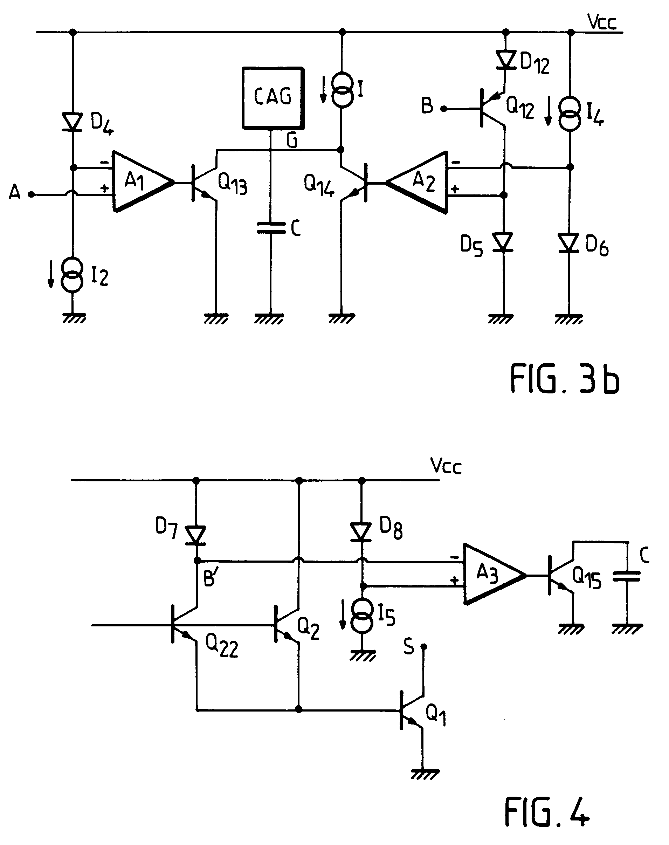

La figure 3a représente un mode de réalisation correspondant à un amplificateur décrit dans l'article de Johan H. HUIJSING et Daniel LINEBARGER paru dans IEEE Solid-State Circuits, vol.SC 20 du 6 décembre 1985, page 1145 (figure 3). Cet amplificateur comporte des transistors Darlington de sortie montés en push-pull ($Q_1$, $Q_2$) d'une part et ($Q_5$, $Q_4$ et $Q_3$) d'autre part.

La figure 3a représente uniquement les transistors de sortie, mais omet le circuit de commande de polarisation en classe AB.

Les deux transistors de sortie sont les transistors $Q_3$ (pnp) et $Q_1$ (npn) montés en push-pull entre une source de tension d'alimentation $V_{cc}$ et le pôle de mode commun (masse) ou une autre source de tension d'alimentation. La sortie S de l'amplificateur est le point commun aux collecteurs des transistors $Q_3$ et $Q_1$. Le transistor $Q_1$ forme un Darlington avec le transistor $Q_2$ (npn). Le transistor $Q_3$ forme un Darlington avec les transistors $Q_5$ (npn) et $Q_4$ (pnp) en cascade. L'émetteur du transistor $Q_5$ est connecté à la base du transistor $Q_4$ et à une source de courant $I_1$. L'émetteur du transistor $Q_4$ est connecté à la base du transistor $Q_3$, et son collecteur est connecté d'une part à l'anode d'une diode $D_{10}$ en direct dont la cathode est à la masse et d'autre part à la base d'un transistor $Q_{10}$ (npn) dont l'émetteur est à la masse et dont le collecteur est connecté à la base du transistor $Q_3$. Le transistor $Q_{10}$ forme ainsi un miroir de courant avec la diode $D_{10}$ et le courant d'émetteur du transistor $Q_{10}$ est égal au courant traversant la diode $D_{10}$.

Le schéma selon l'invention diffère de celui de la publication précitée en ce que le collecteur du transistor $Q_5$ et/ou du transistor $Q_{11}$ n'est pas raccordé directement à la source de tension d'alimentation $V_{cc}$.

En effet, le collecteur du transistor $Q_5$ (point A) est relié à la source de tension d'alimentation $V_{cc}$ à travers une diode $D_3$ en direct, et le collecteur du transistor $Q_2$ (point B) est relié à la source de tension d'alimentation $V_{cc}$ à travers une diode $D_2$ en direct, en série avec une résistance $R_2$.

En outre, le point B est connecté à la base d'un transistor $Q_{11}$ (pnp) dont l'émetteur est relié à la source de tension d'alimentation $V_{cc}$ à travers une résistance $R_{11}$ et dont le collecteur est connecté à la base du transistor $Q_1$.

La figure 3b décrit un dispositif de contrôle de gain auquel peut être connecté le circuit de la figure 3a dont les points A et B ont une tension dont la valeur est représentative d'un état de saturation respectivement des transistors $Q_3$ et $Q_1$. Si le transistor $Q_3$ commence à se saturer, son courant de base augmente et donc le courant d'émetteur du transistor $Q_4$, donc son courant de base, et tend donc à annuler le courant dans le transistor $Q_5$, ce qui intervient quand le courant de base du transistor $Q_4$ devient égal à $I_1$, d'où augmentation significative du potentiel au point A car moins de courant traverse alors la diode $D_3$. Si le transistor $Q_1$ commence à se saturer, son courant de base augmente et donc le courant de collecteur du transistor $Q_2$, ainsi que le courant à travers la diode $D_2$, le courant collecteur du transistor $Q_{11}$, et la chute de tension à travers les résistances $R_2$ et $R_{11}$.

A la figure 3b, un amplificateur différentiel $A_1$ a son entrée non inverseuse connectée au point A, et son entrée inverseuse connectée au point milieu d'une branche série comportant une diode $D_4$ dont l'anode est connectée à la source de tension d'alimentation $V_{cc}$, et dont la cathode est connectée à une source de courant $I_2$. La sortie de l'amplificateur $A_1$ est connectée à la base d'un transistor $Q_{13}$ (npn) dont le collecteur est connecté à la borne non à la masse du condensateur C et dont l'émetteur est à la masse. Lorsque le transistor $Q_3$ sature, le potentiel du point A augmente et lorsqu'il dépasse celui fixé par le courant $I_2$, c'est-à-dire lorsque le courant traversant le transistor $Q_4$ devient inférieur au courant $I_2$, le transistor $Q_{13}$ est passant et décharge le condensateur C de manière à provoquer une baisse du gain par le circuit de contrôle de gain CAG. On choisit $I_2$ égal à une fraction $I_1/n$ du courant $I_1$. Un amplificateur différentiel $A_2$ a son entrée inverseuse connectée au point milieu d'une branche série comportant une source de courant $I_4$ d'intensité donnée connectée à l'anode d'une diode $D_6$ dont la cathode est à la masse. Le point B est connecté à la base d'un transistor $Q_{12}$ (pnp) dont l'émetteur est relié à la source de tension d'alimentation $V_{cc}$ à travers une diode $D_{12}$ en direct et dont le collecteur est relié à la masse à travers une diode en direct $D_5$. Le collecteur est également connecté à l'entrée non inverseuse de l'amplificateur $A_2$. Lorsque le transistor $Q_1$ sature, le collecteur du transistor $Q_2$ voit son courant de collecteur augmenter, et donc le courant à travers la diode $D_2$ et la résistance $R_2$, d'où baisse de tension au point B. Lorsque la chute de tension dans la résistance $R_2$ atteint une tension base-émetteur $V_{be}$ d'un transistor (= une tension $V_S$ d'une diode soit 0,7 V environ), alors ce transistor $Q_{12}$ est mis en conduction. Ce courant est comparé au courant $I_4$ et le transistor $Q_{14}$ est mis en conduction pour décharger le condensateur C dès que le courant de collecteur du transistor $Q_{12}$ dépasse le courant $I_4$.

A la figure 4, on a représenté les transistors $Q_1$ et $Q_2$. Le collecteur du transistor $Q_2$ est maintenant directement connecté à la source de tension d'alimentation $V_{cc}$. Un transistor $Q_{22}$ dont l'émetteur a de préférence une dimension qui est une fraction de celle du transistor $Q_2$, a sa base et son émetteur connectés avec ceux du transistor $Q_2$, et son collecteur (point B') est relié à la source de tension d'alimentation $V_{cc}$ à travers une diode en direct $D_7$. Le point B' est connecté à l'entrée non inverseuse d'un amplificateur différentiel $A_3$ dont l'entrée inverseuse est connectée au point commun d'une branche série comportant une diode $D_8$ en direct dont l'anode est connectée à la source de tension $V_{cc}$ et une source de courant $I_5$ d'intensité donnée. Lorsque le transistor $Q_1$ tend à se saturer, le courant traversant $Q_2$ tend à augmenter et donc celui traversant le transistor $Q_{22}$. Lorsque le courant de collecteur du transistor $Q_{22}$ devient supérieur à $I_5$, le transistor $Q_{15}$ est passant et décharge le condensateur C, ce qui induit une baisse de gain grâce au circuit CAG.

L'application au contrôle automatique de gain peut être mise en oeuvre en combinaison avec d'autres éléments de contrôle de gain par exemple ceux décrits dans la demande de brevet français 89 04407 déposée le 4 avril 1989 par la Demanderesse. La source de courant I peut être commutable et n'induire le chargement du condensateur C que lorsque la tension d'alimentation $V_{cc}$ est d'un premier niveau suffisant. Un circuit peut décharger également le condensateur C à travers une résistance lorsque le niveau de la tension d'alimentation $V_{cc}$ est en dessous d'un deuxième niveau inférieur au premier. Cette dernière méthode permet de maintenir la tension d'alimentation au niveau minimum, mais laisse subsister des distortions de l'ordre de la milliseconde. Si on adjoint une correction de distortion telle que décrite ci-dessus, il en résulte que cette dernière perturbation est pratiquement annulée.

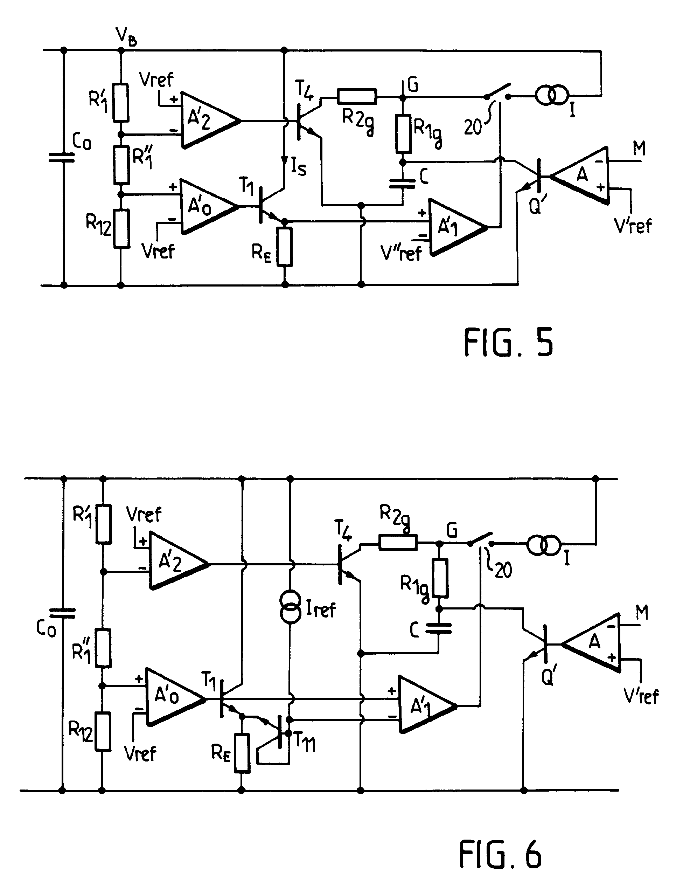

Selon la figure 5, un circuit de contrôle de gain comporte trois résistances en série $R'_1$, $R''_1$ et $R_{12}$ connectées entre des bornes d'alimentation, en parallèle avec un condensateur $C_0$. Un amplificateur $A'_0$ a son entrée non inverseuse connectée au point commun aux résistances $R''_1$ et $R_{12}$ et un amplificateur $A'_2$, son entrée inverseuse connectée au point commun aux résistances $R'_1$ et $R''_1$. Le circuit présente également un transistor $T_1$, présentant une résistance d'émetteur $R_E$, l'émetteur de $T_1$ étant connecté à l'entrée non inverseuse d'un amplificateur $A'_1$, un amplificateur $A'_1$ dont la sortie commande la mise en contact ou non d'une source de courant I avec le point G grâce à un interrupteur 20. L'amplificateur $A'_0$, et le transistor $T_1$ constituent un régulateur shunt connu en sol. L'émetteur du transistor $T_1$ est connecté à l'entrée non inverseuse de l'amplificateur $A'_1$. En outre, la mémorisation et l'utilisation de la tension de contrôle de gain sont réalisées de la manière suivante. Une branche série constituée par une résistance $R_{1g}$ et un condensateur de mémorisation C est connectée entre le pôle de mode commun et l'entrée de contrôle de gain G d'un amplificateur. L'interrupteur 20, par exemple un transistor fonctionnant en régime de commutation, a pour fonction de mettre la source de courant I en contact avec la branche série (point G) lorsque le régulateur shunt dérive du courant (transistor $T_1$ non bloqué), ce qui permet, de charger de manière temporisée le condensateur C pour atteindre le gain maximal. Pour décharger le condensateur C (et produire une diminution du gain en abaissant la tension au point G), on met en oeuvre un dispositif à seuil qui discrimine un deuxième seuil de tension inférieur au seuil du régulateur shunt. Un amplificateur $A'_2$ a

son entrée non inverseuse portée au potentiel $V_{REF}$ et son entrée inverseuse connectée au point commun aux résistances $R'_1$ et $R''_1$.

La sortie de l'amplificateur $A'_2$ est connectée à la base d'un transistor $T_4$ dont le trajet collecteur-émetteur est disposé entre le point G et le pôle de mode commun. Une résistance $R_{2g}$ peut être disposée entre le collecteur du transistor $T_4$ et le point G et sa valeur est choisie de manière à assurer que le transistor $T_4$ soit dans son état de saturation lorsqu'il est commandé à l'ouverture.

La première valeur de seuil $V_0$, qui commande le fonctionnement du régulateur shunt vaut :

$$V_0 = \frac{R'_1 + R''_1 + R_{12}}{R_{12}} V_{REF}$$

La deuxième valeur de seuil $V_1$ qui commande la décharge du condensateur de mémorisation C vaut :

$$V_1 = \frac{R'_1 + R''_1 + R_{12}}{R''_1 + R_{12}} V_{REF} < V_0$$

On obtient alors le fonctionnement suivant. Lorsque $V_B0$, le transistor $T_1$ dérive un courant de shunt $I_s$. Pour $R_EI_s$, la sortie de l'amplificateur $A'_1$ est au niveau maximal, ce qui commande la fermeture de l'interrupteur 20. La source de courant I charge le condensateur C. Lorsque le condensateur C est complètement chargé, le gain de l'amplificateur A est maximal. Lorsque $V_B$ est compris entre $V_1$ et $V_0$, le régulateur shunt ne dérive plus de courant, et l'interrupteur 20 est ouvert. Le condensateur C conserve sa valeur mémorisée. Le condensateur $C_0$ est susceptible de compenser pendant un court instant. Si la valeur de $V_B$ continue de baisser et franchit le deuxième seuil $V_1$, alors le transistor $T_4$ passe à l'état ouvert, et le condensateur C se décharge à travers la résistance $R_{1g}$ (et éventuellement $R_{2g}$). La chute de tension à travers $R_{1g}$ modifie la tension au point G et modifie instantanément le gain. La constante de temps de décharge est très courte, ce qui permet d'abaisser le gain de manière quasi-instantanée. Le transistor $T_4$ doit donc être prévu pour passer un tel courant. La consommation (par exemple celle d'un haut-parleur d'écoute amplifiée) est ainsi diminuée de telle sorte que $V_B$ cesse de décroître et sans avoir à décharger trop fortement C. La valeur de $R_{1g}$ (et éventuellement de $R_{2g}$) est ajustée de préférence pour que la tension aux bornes de C rejoigne la nouvelle valeur à mémoriser avec un seul dépassement de faible amplitude, et de ce fait relativement bref (environ 10 ms en pratique). Par contre, la recharge du condensateur C, déchargé en tout ou partie, ne peut reprendre que lorsque $V_B$ a de nouveau atteint le seuil $V_0$ et que le régulateur shunt dérive un courant $I_S$ significatif. Le condensateur C se recharge alors progressivement grâce à la source de courant I et le gain recommence à augmenter. Cette recharge s'effectue plus lentement que la décharge et est susceptible de s'interrompre dès que le courant shunté $I_s$ est trop faible.

La stabilité du système est donc très bonne. En outre, le condensateur C ne peut se charger que lorsqu'un maximum de courant est disponible. La courbe du gain en fonction de la tension au point G est d'allure croissante.

Comme la décharge de C est rapide, on peut choisir pour $V_1$ une valeur proche de la valeur d'alimentation minimale pour laquelle le fonctionnement de l'amplificateur A est correct (faible distortion). Ceci a également pour avantage que les chutes brutales de gain se situent alors sur des crêtes très importantes de la parole et ne sont pas audibles. En effet, une chute brutale de gain produit une forte distorsion, mais l'oreille ne remarque ce type de distorsion que lorsque leur fréquence de répétition est rapide.

Il n'est pas nécessaire d'utiliser un condensateur de valeur élevée.

On peut choisir pour C une valeur de $0,5\mu F$, et une source de courant de $1\mu A$. La présence éventuelle de la résistance $R_{2g}$ permet de limiter si besoin est le courant de décharge à travers le transistor $T_4$ et d'éviter le cas échéant une décharge trop brutale du condensateur C qui entraînerait un passage au gain minimum chaque fois que se produit une perturbation. En effet, le condensateur $C_0$ met un certain temps à se recharger, ce qui fait que la tension $V_B$ met un certain temps a atteindre de nouveau les seuils $V_1$ et $V_0$.

A titre d'exemple, on peut avoir $R_{1g} = 3,6k\Omega$ et $R_{2g} = 0\Omega$. En pratique, l'écart entre $V_0$ et $V_1$ peut être de l'ordre de quelques centaines de mV pour une tension $V_0$ de l'ordre de 3,5V.

Au point commun à la résistance $R_{1g}$ et au condensateur, est également connecté le collecteur du transistor Q' (ou ceux des transistors $Q_{13}$ et $Q_{14}$), c'est-à-dire que l'on cumule les actions sur le contrôle de gain, à savoir une action instantanée sur les phénomènes de saturations et/ou une action temporisée sur la valeur de la tension $V_B$.

La figure 6 correspond à un mode de réalisation selon lequel on s'affranchit des variations dûes au procédé de fabrication. Au lieu de comparer $R_EI_s$ et $V''_{REF}$, on compare $I_s$ à un courant de référence $I_{REF}$ (à un coefficient multiplicateur près). Pour ce faire, une source de courant de référence $I_{REF}$ est connectée entre la source de tension d'alimentation et l'entrée inverseuse de l'amplificateur $A'_1$, et un transistor $T_{11}$ monté en diode (transistor npn dont le collecteur et la base sont court-circuités) est monté entre l'entrée inverseuse de l'amplificateur $A_1$ et l'émetteur du transistor $T_1$ de même type. L'entrée non inverseuse de l'amplificateur $A'_1$ est connectée à la base du transistor $T_1$.

L'amplificateur $A_1$ agit alors en comparateur et mesure

$$I_S<r\, I_{REF}$$

r étant le rapport entre les surfaces d'émetteur des transistors $T_1$ et $T_{11}$.

Un avantage supplémentaire est que $R_E$ n'intervenant pas dans la mesure, sa valeur peut être choisie pour optimiser la stabilité de la boucle régulant la tension $V_B$. En outre, il est relativement facile d'obtenir que r et $I_{REF}$ varient peu l'un par rapport à l'autre avec le procédé alors qu'il est plus difficile de déterminer $V'_{REF}$ et $R_E$ en corrélation l'un par rapport à l'autre.

## Revendications

1. Circuit intégré comportant un dispositif de détection de l'état de saturation d'un transistor de sortie dont le trajet collecteur-émetteur est destiné à être traversé par un courant de sortie et comportant un circuit à seuil agencé pour commuter lorsqu'un paramètre représentatif d'un état de saturation franchit un seuil donné, caractérisé en ce qu'il comporte un transistor de commande (Q) agencé de manière à fournir au moins une partie du courant de base du transistor ($Q_0$) de sortie et en ce que le circuit à seuil (A, $V'_{ref}$) est agencé pour commuter lorsque la valeur du courant traversant le trajet collecteur-émetteur du transistor de commande (Q) dépasse un niveau donné.

2. Circuit intégré selon la revendication 1, caractérisé en ce que le circuit à seuil comporte une première diode ($D_3$) disposée en série entre ledit trajet collecteur-émetteur du transistor de commande ($Q_5$) et une source de tension d'alimentation, une deuxième diode ($D_4$) disposée en série entre une première source de courant ($I_2$) d'intensité donnée et la source de tension d'alimentation, le point commun à la première diode ($D_3$) et audit trajet collecteur-émetteur du transistor de commande ($Q_5$) étant connecté à une première entrée d'un premier amplificateur différentiel ($A_1$) et le point commun à la deuxième diode ($D_4$) et à la première source de courant ($I_2$) étant connecté à une deuxième entrée du premier amplificateur différentiel, dont la sortie constitue la sortie du circuit à seuil.

3. Circuit intégré selon la revendication 1, caractérisé en ce que le circuit à seuil comporte une première branche série, comprenant une deuxième diode ($D_2$) et une première résistance ($R_2$), et disposée en série entre ledit trajet collecteur-émetteur du transistor de commande ($Q_2$) et la source de tension d'alimentation, et un premier transistor de contrôle ($Q_{11}$) dont la base est connectée au point commun (B) entre la première branche série et le trajet collecteur-émetteur du transistor de commande, le trajet collecteur-émetteur du premier transistor de contrôle étant connecté d'une part à une première borne d'une deuxième résistance ($R_{11}$) dont la deuxième borne est connectée à la source de tension d'alimentation et d'autre part à la base du transistor de sortie ($Q_1$), en ce que la base du premier transistor de contrôle ($Q_{11}$) est connectée à la base d'un deuxième transistor de contrôle ($Q_{12}$) dont le trajet collecteur-émetteur est connecté d'une part à une première borne d'une troisième diode ($D_{12}$) en direct dont la deuxième borne est connectée à la source de tension d'alimentation et d'autre part à une première borne d'une quatrième diode ($D_5$) dont la deuxième borne est connectée à une deuxième source de tension d'alimentation, en ce qu'il comporte une deuxième source de courant ($I_4$) d'intensité donnée connectée en série avec une première borne d'une cinquième diode ($D_6$) en direct dont la deuxième borne est connectée à la deuxième source de tension d'alimentation, en ce que la première borne de la quatrième diode ($D_5$) est connectée à une première entrée d'un deuxième amplificateur différentiel ($A_2$) et en ce que la première borne de la cinquième diode ($D_6$) est connectée à une deuxième entrée du deuxième amplificateur différentiel ($A_2$), dont la sortie constitue la sortie du circuit à seuil.

4. Circuit selon la revendication 1, caractérisé en ce qu'il comporte un troisième transistor de contrôle ($Q_{22}$) dont la base est connectée à celle du transistor de commande ($Q_2$) et dont le trajet collecteur-émetteur est connecté d'une part à une première borne d'une sixième diode ($D_7$) en direct dont la deuxième borne est connectée à la première source de tension d'alimentation et d'autre part à la base du transistor de sortie, en ce qu'il comporte une septième diode ($D_8$) dont une première borne est connectée à une troisième source de courant ($I_5$) d'intensité donnée et dont une deuxième borne est connectée à la première source de tension d'alimentation, en ce que la première borne de la sixième diode ($D_7$) est connectée à une première entrée d'un troisième amplificateur différentiel ($A_3$) et en ce que la première borne de la septième diode ($D_8$) est connectée à une deuxième entrée du troisième amplificateur différentiel ($A_3$), dont la sortie constitue la sortie du circuit à seuil.

5. Circuit selon une des revendications précédentes caractérisé en ce que la sortie du circuit à seuil est connectée à l'entrée d'un circuit de commutation (Q', $Q_{13}$, $Q_{14}$, $Q_{15}$) dont la sortie est agencée pour charger ou décharger un condensateur de mémorisation (C) d'une tension de contrôle de gain en fonction de la tension en sortie du circuit à seuil, ledit condensateur (C) ayant une borne reliée à une entrée de contrôle de gain d'un circuit de contrôle de gain (CAG) d'un circuit amplificateur qui comporte ledit transistor de sortie ($Q_0$).

6. Circuit selon la revendication 5 caractérisé en ce qu'il comporte :
   - un régulateur shunt agencé pour réguler à une première valeur de référence la tension d'alimentation du circuit amplificateur, le circuit de contrôle de gain étant agencé pour agir sur le gain du circuit amplificateur au moins en fonction du courant traversant le régulateur shunt.
   - un premier moyen pour faire varier selon une première loi de variation ladite tension mémorisée par le condensateur de mémorisation (C), dans un premier sens correspondant à une augmentation du gain lorsque le régulateur shunt est traversé par un courant et pour interrompre cette action dans le cas contraire.
   - et un deuxième moyen pour faire varier selon une deuxième loi de variation plus rapide que la première loi, ladite tension mémorisée dans un deuxième sens opposé au premier lorsque la tension d'alimentation disponible aux bornes d'alimentation de l'amplificateur descend en dessous d'une deuxième valeur de référence inférieure à la première valeur de référence.

7. Circuit selon la revendication 6 caractérisé en ce que la deuxième valeur de référence est voisine de la tension d'alimentation minimale correspondant à un fonctionnement correct de l'amplificateur.

8. Circuit selon une des revendications 6 ou 7 caractérisé en ce qu'il comporte une résistance dont une première borne est connectée à ladite borne du condensateur (C) et dont une deuxième borne est connectée à ladite entrée de contrôle de gain (G) et en ce que la sortie du circuit de commutation (Q') est connectée à ladite borne du condensateur (C).

9. Circuit selon une des revendications 6 à 8 caractérisé en ce que le premier moyen comporte un comparateur de courant ($T_{11}$, $T_1$, $R_E$) pour comparer le courant traversant le régulateur shunt à un courant de référence ($I_{REF}$).

**Patentansprüche**

1. Integrierte Schaltung mit einer Vorrichtung zum Detektieren des Sättigungszustandes eines Endtransistors, durch dessen Kollektor-Emitter-Übergang ein Ausgangsstrom fließen soll und der eine Schwellenschaltung umfaßt, die so angeordnet ist, daß sie umschaltet, wenn ein für einen Sättigungszustand repräsentativer Parameter einen gegebenen Schwellenwert überschreitet, dadurch gekennzeichnet, daß er einen Steuertransistor (Q) umfaßt, der so angeordnet ist, daß er mindestens einen Teil des Basisstroms des Endtransistors ($Q_0$) liefert, und daß die Schwellenschaltung (A, $V'_{ref}$) so angeordnet ist, daß sie umschaltet, wenn der Wert des durch den Kollektor-Emitter-Übergangs des Steuertransistors (Q) fließenden Stroms ein bestimmtes Niveau überschreitet.

2. Integrierte Schaltung nach Anspruch 1, dadurch gekennzeichnet, daß die Schwellenschaltung eine erste Diode ($D_3$), die zwischen dem Kollektor-Emitter-Übergang des Steuertransistors ($Q_5$) und einer Versorgungsspannungsquelle in Reihe geschaltet ist, eine zweite Diode ($D_4$), die zwischen einer ersten Stromquelle ($I_2$) mit vorgegebener Stromstärke und der Versorgungsspannungsquelle in Reihe geschaltet ist, wobei der Verbindungspunkt der ersten Diode ($D_3$) und des Kollektor-Emitter-Übergangs des Steuertransistors ($Q_5$) mit einem ersten Eingang eines ersten Differentialverstärkers ($A_1$) und der Verbindungspunkt der zweiten Diode ($D_4$) und der ersten Stromquelle ($I_2$) mit einem zweiten Eingang des ersten Differentialverstärkers verbunden sind, dessen Ausgang den Ausgang der Schwellenschaltung bildet, umfaßt.

3. Integrierte Schaltung nach Anspruch 1, dadurch gekennzeichnet, daß die Schwellenschaltung eine erste Serienschaltung mit einer zweiten Diode ($D_2$) und einem ersten Widerstand ($R_2$), die zwischen dem Kollektor-Emitter-Übergang des Steuertransistors ($Q_2$) und der Versorgungsspannungsquelle in Reihe geschaltet ist, und einen ersten Steuertransistor ($Q_{11}$) umfaßt, dessen Basis mit dem Verbindungspunkt (B) zwischen der ersten Serienschaltung und dem Kollektor-Emitter-Übergang des Steuertransistors verbunden ist, wobei der Kollektor-Emitter-Übergang des ersten Steuertransistors einerseits mit einem ersten Anschluß eines zweiten Widerstands ($R_{11}$), dessen zweiter Anschluß mit der Versorgungsspannungsquelle verbunden ist, und andererseits mit der Basis des Endtransistors ($Q_{11}$) verbunden ist, daß die Basis des ersten Steuertransistors ($Q_{11}$) mit der Basis eines zweiten Steuertransistors ($Q_{12}$) verbunden ist, dessen Kollektor-Emitter-Übergang einerseits direkt mit einem ersten Anschluß einer dritten Diode ($D_{12}$), deren zweiter Anschluß mit der Versorgungsspannungsquelle verbunden ist, und andererseits mit einem ersten Anschluß einer vierten Diode (D₅) verbunden ist, deren zweiter Anschluß mit einer zweiten Versorgungsspannungsquelle verbunden ist, daß sie eine zweite Stromquelle (I₄) mit einer vorgegebenen Stromstärke umfaßt, die mit einem ersten Anschluß einer fünften Diode (D₆) direkt in Reihe geschaltet ist, deren zweiter Anschluß mit der zweiten Versorgungsspannungsquelle verbunden ist, daß der erste Anschluß der vierten Diode (D₅) mit einem ersten Eingang eines zweiten Differentialverstärkers (A₂) verbunden ist und daß der erste Anschluß der fünften Diode (D₆) mit einem zweiten Eingang eines zweiten Differentialverstärkers (A₂) verbunden ist, dessen Ausgang den Ausgang der Schwellenschaltung bildet.

4. Schaltung nach Anspruch 1, dadurch gekennzeichnet, daß sie einen dritten Steuertransistor (Q₂₂) umfaßt, dessen Basis mit der des Steuertransistors (Q₂) verbunden ist und der Kollektor-Emitter-Übergang einerseits direkt mit einem ersten Anschluß einer sechsten Diode (D₇), deren zweiter Anschluß mit einer ersten Versorgungsspannungsquelle verbunden ist, und andererseits mit der Basis des Endtransistors verbunden ist, daß sie eine siebte Diode (D₈) umfaßt, deren erster Anschluß mit einer dritten Stromquelle (I₅) einer vorgegebenen Stromstärke und deren zweiter Anschluß mit der ersten Versorgungsspannungsquelle verbunden ist, daß der erste Anschluß der sechsten Diode (D₇) mit einem ersten Eingang eines dritten Differentialverstärkers (A₃) verbunden ist und daß der erste Anschluß der siebten Diode (D₈) mit einem zweiten Eingang des dritten Differentialverstärkers (A₃) verbunden ist, dessen Ausgang den Ausgang der Schwellenschaltung bildet.

5. Schaltung nach einem der vorhergehenden Ansprüche, dadurch gekennzeichnet, daß der Ausgang der Schwellenschaltung mit dem Eingang einer Kommutierungsschaltung (Q′, Q₁₃, Q₁₄, Q₁₅) verbunden ist, deren Ausgang so angeordnet ist, daß er einen Speicherkondensator (C) für eine Verstärkungsregelungsspannung in Abhängigkeit von der Spannung am Ausgang der Schwellenschaltung laden oder entladen kann, wobei der Kondensator (C) einen mit einem Verstärkungsregelungseingang einer Verstärkungsregelungsschaltung (CAG) einer Verstärkerschaltung, die den Endtransistor (Q₀) umfaßt, verbundenen Anschluß hat.

6. Schaltung nach Anspruch 5, dadurch gekennzeichnet, daß sie folgendes umfaßt:
   - einen Nebenschlußregler, der so angeordnet ist, daß er die Versorgungsspannung der Verstärkerschaltung auf einen ersten Referenzwert regelt, wobei die Verstärkungsregelungsschaltung so angeordnet ist, daß sie mindestens in Abhängigkeit vom durch den Nebenschlußregler fließenden Strom auf die Verstärkung der Verstärkerschaltung einwirkt;
   - ein erstes Mittel zum Verändern der vom Speicherkondensator (C) gespeicherten Spannung nach einer ersten Änderungsregel in einer ersten Richtung entsprechend einer Erhöhung der Verstärkung, wenn durch den Nebenschlußregler ein Strom fließt, und zum Unterbrechen dieses Vorgangs, wenn dies nicht der Fall ist;
   - und ein zweites Mittel zum schnelleren Verändern der gespeicherten Spannung als beim ersten Mittel nach einer zweiten Änderungsregel in einer zweiten, der ersten entgegengesetzten Richtung, wenn die an den Anschlußklemmen des Verstärkers anliegende Versorgungsspannung unter einen zweiten Referenzwert fällt, der niedriger als der erste Referenzwert ist.

7. Schaltung nach Anspruch 6, dadurch gekennzeichnet, daß der zweite Referenzwert nahe der niedrigsten Versorgungsspannung, bei der der Verstärker noch einwandfrei funktioniert, liegt.

8. Schaltung nach einem der Ansprüche 6 oder 7, dadurch gekennzeichnet, daß sie einen Widerstand umfaßt, dessen erster Anschluß mit dem Anschluß des Kondensators (C) und dessen zweiter Anschluß mit dem Verstärkungsregelungseingang (G) verbunden ist, und daß der Ausgang der Kommutierungsschaltung (Q′) mit dem Anschluß des Kondensators (C) verbunden ist.

9. Schaltung nach einem der Ansprüche 6 bis 8, dadurch gekennzeichnet, daß das erste Mittel einen Stromvergleicher (T₁₁, T₁, R_E) zum Vergleichen des durch den Nebenschlußregler fließenden Stroms mit einem Referenzstrom (I_REF) umfaßt.

## Claims

1. Integrated circuit which comprises a detection arrangement for detecting the condition of saturation of one output transistor having a collector-emitter path through which an output current is passed, and includes a threshold circuit arranged to switch when a representative parameter of a saturation condition exceeds a given threshold, characterized in that it comprises a control transistor (Q) arranged to produce at least part of the base current of the output transistor ($Q_0$) and in that the threshold circuit ($A_1V'_{ref}$) is arranged to switch when the value of the current passing through the collector-emitter path of the control transistor (Q) exceeds a given level.

2. Integrated circuit as claimed in Claim 1, characterized in that the threshold circuit comprises a first diode ($D_3$) connected in series between said collector-emitter path of the control transistor ($Q_5$) and a supply voltage source, a second diode ($D_4$) connected in series between a first current source ($I_2$) of given strength (amplitude) and the supply voltage source, while the junction of the first diode ($D_3$) and said collector-emitter path of the control transistor ($Q_5$) is connected to a first input of a first differential amplifier ($A_1$) and the junction of the second diode ($D_4$) and the first current source ($I_2$) is connected to a second input of the first differential amplifier whose output forms the output of the threshold circuit.

3. Integrated circuit as claimed in Claim 1, characterized in that the threshold circuit comprises a first serial branch, which includes a second diode ($D_2$) and a first resistor ($R_2$) and is connected in series between said collector-emitter path of the control transistor ($Q_2$) and the supply voltage source, and a first monitoring transistor ($Q_{11}$) whose base is connected to the junction (B) between the first serial branch and the collector-emitter path of the control transistor, while the collector-emitter path of the first monitoring transistor is connected to a first terminal of a second resistor ($R_{11}$) whose second terminal is connected to the supply voltage source and is also connected to the base of the output transistor ($Q_1$), in which circuit the base of the first monitoring transistor ($Q_{11}$) is connected to the base of a second monitoring transistor ($Q_{12}$) whose collector-emitter path is connected to a first terminal of a third d.c. diode ($D_{12}$) whose second terminal is connected to the supply voltage source and which collector-emitter path is also connected to a first terminal of a fourth diode ($D_5$) whose second terminal is connected to a second supply voltage source, which circuit includes a second current source ($I_4$) having a given strength connected in series to a first terminal of a fifth d.c. diode ($D_6$) whose second terminal is connected to the second supply voltage source, in which circuit the first terminal of the fourth diode ($D_5$) is connected to a first input of a second differential amplifier ($A_2$) and in which circuit the first terminal of the fifth diode ($D_6$) is connected to a second input of the second differential amplifier ($A_2$) whose output forms the output of the threshold circuit.

4. Circuit as claimed in Claim 1, characterized in that the circuit comprises a third monitoring transistor ($Q_{22}$) whose base is connected to that of the control transistor ($Q_2$) and whose collector-emitter path is connected to a first terminal of a sixth d.c. diode ($D_7$) whose second terminal is connected to the first supply voltage source and which collector-emitter path is also connected to the base of the output transistor, and which circuit includes a seventh diode ($D_8$) whose first terminal is connected to a third current source ($I_5$) having a given strength and whose second terminal is connected to the first supply voltage source, in which circuit the first terminal of the sixth diode ($D_7$) is connected to a first input of a third differential amplifier ($A_3$) and in which circuit the first terminal of the seventh diode ($D_8$) is connected to a second input of the third differential amplifier ($A_3$) whose output forms the output of the threshold circuit.

5. Circuit as claimed in one of the preceding Claims, characterized in that the output of the threshold circuit is connected to the input of a switching circuit ($Q'_1$, $Q_{13}$, $Q_{14}$, $Q_{15}$) whose output is arranged to charge a storage capacitor (C) with a gain control voltage or discharge same as a function of the polarity of the output voltage of said threshold circuit, said capacitor (C) having one terminal connected to a gain control input of a gain control circuit (CAG) of an amplifier circuit which comprises said output transistor ($Q_0$).

6. Circuit as claimed in Claim 5, characterized in that it comprises
   - a shunt regulator arranged to adjust the supply voltage of the amplifier circuit to a first reference value, the gain control circuit being arranged to influence (control) the gain of the amplifier circuit, at least as a function of the current passing through the shunt regulator;
   - a first means for varying, according to a first variation law said voltage stored by the storage capacitor (C), in a first direction corresponding to an increase of the gain when a current passes through the shunt regulator and for interrupting this action in the opposite case;
   - and a second means for varying, according to a second variation law faster than said first law, said stored voltage in a second direction opposite to the first direction when the supply voltage available at the supply terminals of the amplifier drops below a second reference value which is lower than the first reference value.

7. Circuit as claimed in Claim 6, characterized in that the second reference value is close to the minimum supply voltage at which the amplifier operates properly.

8. Circuit as claimed in one of the Claims 6 or 7, characterized in that the circuit comprises a resistor having a first terminal connected to said terminal of the capacitor (C) and a second terminal connected to said gain control input (G), and the output of the switching circuit (Q') is connected to said terminal of the capacitor (C).

9. Circuit as claimed in one of the Claims 6 to 8, characterized in that the first means comprise a current comparator ($T_{11}$, $T_1$, $R_E$) for comparing the current passing through the shunt regulator to a reference current ($I_{REF}$).

FIG. 1

FIG. 2

FIG. 3a

12

FIG. 3b

FIG. 4

FIG. 5

FIG. 6

14